# EUROPEAN PATENT APPLICATION

(11) **EP 3 379 388 A1**
(43) Date of publication of application: **26.09.2018**
(21) Application number: 18163793.5
(22) Date of filing: 23.03.2018
(51) Int. Cl.: G06F 3/01, G02F 1/1343, G06F 3/041, G09G 3/30

(54) **SYSTEMS AND METHODS FOR IN-CELL HAPTICS**

(30) Priority: 23.03.2017 US 201715467456
(71) Applicant: Immersion Corporation, San Jose, CA 95134 (US)
(72) Inventor: CRUZ-HERNANDEZ, Juan Manuel, Montreal, Québec H2W 2R2 (CA); KHOSHKAVA, Vahid, Montreal, Québec H2W 2R2 (CA); OLIEN, Neil, Montreal, Québec H2W 2R2 (CA)
(74) Representative: McDougall, Robert Campbell

(57) **Abstract**

One illustrative example of the present disclosure includes a visual display (102) for displaying one or more images. The visual display (102) may include a haptically-enabled cell (104) forming a pixel of the visual display. The haptically-enabled cell (104) may include an anode (204a), a cathode (212a), and/or a light-emitting element (206a) having a light-emitting material. The light-emitting element (206a) may be positioned between the anode (204a) and the cathode (212a). The light-emitting material may be configured to emit visible light in response to an electrical signal communicated by the anode (204a) or the cathode (212a). The haptically-enabled cell (104) may include a haptic output device (210) configured to output a haptic effect in response to a haptic signal.

## Description

### Field of the Invention

The present invention relates to the field of user interface devices. More specifically, the present invention relates to in-cell haptics.

### Background

Computing devices may use visual, audio, and haptic feedback to provide information to a user. But such haptic feedback is typically provided by haptic output devices that are prohibitively large, expensive, and bulky for today's progressively smaller computing devices. There is a need for new types of haptic output devices that are smaller, less expensive, and more easily integrated with computing devices.

### Background

One example of the present disclosure includes a visual display for displaying one or more images. The visual display may include a haptically-enabled cell forming a pixel of the visual display. The haptically-enabled cell may include an anode, a cathode, and/or a light-emitting element comprising a light-emitting material, the light-emitting element positioned between the anode and the cathode. The light-emitting material may be configured to emit visible light in response to an electrical signal communicated by the anode or the cathode. The haptically-enabled cell may include a haptic output device configured to output a haptic effect in response to a haptic signal.

The display may be modified in any suitable way as disclosed herein including, but not limited to, any one or more of the following. For example, the haptic output device may include a smart material, a piezoelectric material, or a shape memory material. In some embodiments, the haptically-enabled cell includes at least one electrode coupled to the haptic output device and configured to control the haptic output device separately from the light-emitting element, the at least one electrode being separate from the anode and the cathode. The haptic signal may include a voltage applied across (i) the at least one electrode, and (ii) the anode or the cathode. In some embodiments, the anode is a first anode; the cathode is a first cathode; the light-emitting element is a first light-emitting element; and the haptically-enabled cell further comprises: a second anode; a second cathode; and a second light-emitting element positioned between the second anode and the second cathode, the second light-emitting element being different from the first light-emitting element and configured to emit visible light in response to another electrical signal communicated by the second anode or the second cathode; and the haptic output device is positioned between the first light-emitting element and the second light-emitting element. The visual display may further comprise a plurality of haptically-enabled cells forming a plurality of pixels, each haptically-enabled cell of the plurality of haptically-enabled cells being individually controllable to generate haptic effects. In some embodiments, the haptically-enabled cell further comprises a base substrate on which the anode is positioned and an upper substrate positioned overtop of the cathode. The haptic output device may be configured to deform a surface of the visual display by bending in an amount configured to apply a force to the upper substrate, the force configured to cause the upper substrate to change shape and thereby cause the surface of the visual display to deform. In some embodiments, the upper substrate is non-uniform in thickness and has a thickest portion, and wherein the haptic output device is configured to output the haptic effect to a portion of the upper substrate that is thinner than the thickest portion. The haptically-enabled cell may further comprise a touch sensor. In some embodiments, the haptic output device, the haptically-enabled cell, and the visual display are deformable. In some embodiments, the visual display is a light-emitting diode (LED) display having a plurality of pixels arranged in a two-dimensional matrix, each pixel of the plurality of pixels comprising a respective haptically-enabled cell. The plurality of haptically enabled cells may be selectively operable according to a matrix addressing scheme.

Another example of the present disclosure includes a method of manufacturing a visual display that includes a haptically-enabled cell forming a pixel of the visual display. The method may include coupling an anode to a base substrate of the haptically-enabled cell. The method may include electrically coupling a light-emitting element comprising a light-emitting material to the anode. The light-emitting material may be configured to emit visible light in response to an electrical signal communicated by the anode or a cathode. The method may include electrically coupling the cathode to the light-emitting element. The method may include coupling a haptic output device to the base substrate. The haptic output device may be configured to output a haptic effect in response to a haptic signal.

The method may be modified in any suitable way as disclosed herein including, but not limited to, any one or more of the following. For example, the haptic output device may include a smart material, a piezoelectric material, or a shape memory material. In some embodiments, the method further comprises: electrically coupling at least one electrode to the haptic output device to control the haptic output device separately from the light-emitting element, the at least one electrode being separate from the anode and the cathode. In some embodiments, the anode is a first anode, the cathode is a first cathode, and the light-emitting element is a first light-emitting element, and the method further comprises: coupling a second anode to the base substrate of the haptically-enabled cell; electrically coupling a second light-emitting element to the second anode, the second light-emitting element being different from the first light-emitting element and configured to emit visible light in response to another electrical signal communicated by the second anode or a second cathode; electrically coupling the second cathode to the second light-emitting element; and positioning the haptic output device between the first light-emitting element and the second light-emitting element. The method may further comprise coupling an upper substrate overtop of the cathode, wherein the upper substrate is non-uniform in thickness and has a thickest portion, and wherein the haptic output device is configured to output the haptic effect to a portion of the upper substrate that is thinner than the thickest portion.

Yet another example of the present disclosure includes a method for operating a display that includes haptically-enabled cells. The method may include providing a visual display that includes a plurality of haptically-enabled cells forming a plurality of pixels of the visual display. Each haptically-enabled cell of the plurality of haptically-enabled cells may include an anode, a cathode, and/or a light-emitting element comprising a light-emitting material. The light-emitting element may be positioned between the anode and the cathode. The light-emitting material may be configured to emit visible light in response to an electrical signal communicated by the anode or the cathode. Each haptically-enabled cell of the plurality of haptically-enabled cells may include a haptic output device configured to output haptic effects in response to haptic signals. The method may include determining that a haptic effect is to be output. The method may include selecting a haptically-enabled cell from among the plurality of haptically-enabled cells based on the haptic effect. The method may include outputting the haptic effect via the haptic output device of the selected haptically-enabled cell. Some or all of the steps of the method may be implemented by a processing device.

The method may be modified in any suitable way as disclosed herein including, but not limited to, any one or more of the following. For example, the haptic output device may include a smart material, a piezoelectric material, or a shape memory material. In some embodiments, each haptically-enabled cell of the plurality of haptically-enabled cells is individually controllable by the processing device to generate the haptic effects. In some embodiments, outputting the haptic effect comprises: deforming a surface of the visual display by bending the haptic output device in an amount configured to apply a force to an upper substrate positioned overtop of the cathode, the force configured to cause the upper substrate to change shape and thereby cause the surface of the visual display to deform. The method may further comprise: displaying an image on the visual display at least in part by stimulating the light-emitting element in the selected haptically-enabled cell by communicating the electrical signal via the anode or the cathode. The method may further comprise: detecting a contact with the visual display based on a sensor signal from a touch sensor incorporated into the selected haptically-enabled cell; and determining the haptic effect based on the contact with the visual display.

Still another example of the present disclosure includes a device that includes a plurality of haptically-enabled cells arranged in a matrix for displaying an image and outputting haptic effects. Each haptically-enabled cell of the plurality of haptic cells may include an anode, a cathode, and/or a light-emitting element comprising a light-emitting material. The light-emitting element may be positioned between the anode and the cathode. The light-emitting material may be configured to emit visible light in response to an electrical signal communicated by the anode or the cathode. Each haptically-enabled cell of the plurality of haptic cells may include a haptic output device configured to output haptic effects in response to haptic signals. The device may be modified in any suitable way as disclosed herein including, but not limited to, the following. For example, each haptically-enabled cell is independently controllable from a remainder of the plurality of haptically-enabled cells, and wherein the light-emitting element is individually controllable from the haptic output device in each haptically-enabled cell

These examples are mentioned not to limit or define the limits of the present subject matter, but to aid understanding thereof. These and other examples are discussed in the Detailed Description, and further description is provided there. Advantages offered by various examples may be further understood by examining this specification and/or by practicing one or more examples of the claimed subject matter.

### Brief Description of the Drawings

A full and enabling disclosure is set forth more particularly in the remainder of the specification. The specification makes reference to the following appended figures.
FIG. 1 is an example of a computing device for producing in-cell haptics according to some aspects.
FIG. 2 is an example of a haptically-enabled cell according to some aspects.
FIG. 3 is a cross-sectional side view of the haptically-enabled cell of FIG. 2 according to some aspects.
FIG. 4 is another example of a haptically-enabled cell according to some aspects.
FIG. 5 is another example of a haptically-enabled cell according to some aspects.
FIG. 6 is another example of a haptically-enabled cell according to some aspects.
FIG. 7 is another example of a haptically-enabled cell according to some aspects.
FIG. 8 is a cross-sectional side view of another example of a haptically-enabled cell according to some aspects.
FIG. 9 is a cross-sectional side view of an example of a visual display according to some aspects.
FIG. 10 is a block diagram of an example of a computing device for implementing in-cell haptics according to some aspects.
FIG. 11 is a flow chart of an example of a process for manufacturing a visual display that includes a haptically-enabled cell according to some aspects.
FIG. 12 is a flow chart of an example of a process for operating a visual display that includes a haptically-enabled cell according to some aspects.
FIG. 13 is an exploded view of another example of a haptically-enabled cell according to some aspects.
FIGS. 14A-B are examples of a vehicle computing-system for producing in-cell haptics according to some aspects.

### Detailed Description

Reference will now be made in detail to various and alternative illustrative examples and to the accompanying drawings. Each example is provided by way of explanation and not as a limitation. It will be apparent to those skilled in the art that modifications and variations may be made. For instance, features illustrated or described as part of one example may be used in another example to yield a still further example. Thus, it is intended that this disclosure includes modifications and variations as come within the scope of the appended claims and their equivalents.

### Illustrative Example of In-Cell Haptics

One illustrative example of the present disclosure includes a mobile device, such as a smart phone. The mobile device has a visual display that is touch-sensitive. For example, the visual display may detect contacts and transmit sensor signals associated with the contacts to an internal processing device.

The visual display includes a matrix of haptically-enabled cells. Each haptically-enabled cell includes visual-display components and haptic components integrated into a single unit that forms a pixel of the visual display. In one example, a haptically-enabled cell includes an anode, a cathode, and a light-emitting element comprising a light-emitting material. The light-emitting element may be positioned (e.g., spatially positioned, mechanically coupled, electrically coupled, or any combination of these) between the anode and the cathode. The light-emitting material emits visible light in response to an electrical signal communicated by the anode, the cathode, or both. A user may perceive the visible light as a certain color, such as red, green, or blue. The haptically-enabled cell also includes a haptic output device for outputting haptic effects. Examples of the haptic output device include smart materials, piezoelectric materials, shape memory alloys, or any combination of these. The haptic output device may be separately and selectively controllable from the light-emitting element. Thus, a single haptically-enabled cell may output a pixel for an image, a haptic effect, or both. Visual displays that include haptically-enabled cells may be thinner, cheaper, more precisely controllable, and easier to manufacture than other types of haptic feedback devices.

The mobile device operates the haptically-enabled cells to output images and haptic effects. For example, the mobile device may operate the haptically-enabled cells to output a graphical user interface (GUI), such as for a multimedia player. If a user presses a button in the GUI (e.g., a play button for playing back video content or audio content), the mobile device may responsively cause a haptically-enabled cell to output a haptic effect. For example, the mobile device may cause a haptic output device of a haptically-enabled cell to generate a vibration while the user is contacting the button in the GUI. The user may perceive the vibration at the surface of the visual display. In some examples, the vibration is configured to provide the user with information, such as a confirmation that the mobile device detected the button press.

The mobile device may operate any number and combination of haptically-enabled cells in sequence or in concert to output any number and combination of images and haptic effects. For example, the mobile device may operate all the haptically-enabled cells simultaneously to cause the entire visual display to vibrate. As another example, the mobile device may operate the haptically-enabled cells in a particular region of the visual display to provide localized haptic effects. As still another example, the mobile device may individually operate a series of haptically-enabled cells in a particular sequence to provide haptic effects that, for example, simulate movement.

The description of the illustrative example above is provided merely as an example, not to limit or define the limits of the present subject matter. Various other examples are described herein and variations of such examples would be understood by one of skill in the art. Advantages offered by various examples may be further understood by examining this specification and/or by practicing one or more examples of the claimed subject matter.

### Illustrative Systems and Devices for In-Cell Haptics

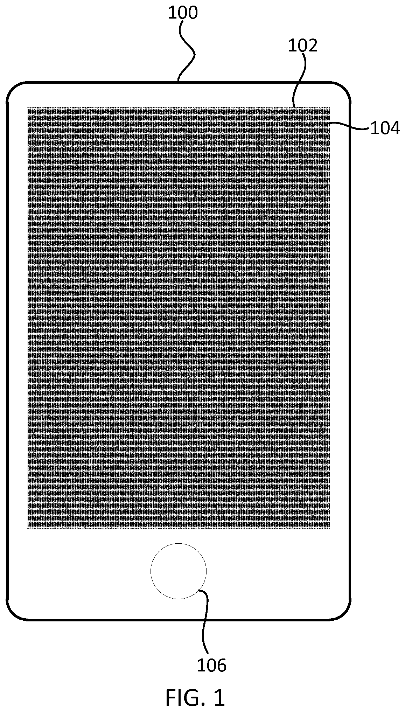

FIG. 1 is an example of a computing device 100 for producing in-cell haptics according to some aspects. In this example, the computing device 100 is a smartphone. In other examples, the computing device 100 may include a tablet, e-reader, gaming system, personal organizer, laptop computer, vehicle computer, desktop computer, kiosk, instrument panel, camera, alarm system, music player, medical device, television, computer monitor, or any other device having a visual display. In some examples, the computing device 100 is a wearable device, such as a watch, ring, armband, glasses, glove, wristband, bracelet, etc.

The computing device 100 includes a visual display 102. The visual display 102 may include a Light Emitting Diode (LED) display, an Organic Light Emitting Diode (OLED) display, a liquid crystal display (LCD), or a plasma display. In some examples, the visual display 102 is a touch-screen display through which a user provides input to the computing device 100 and receives output from the computing device 100. The computing device 100 may also have other user interface components, such as a button 106, slider, switch, knob, or any combination of these.

The visual display 102 includes one or more haptically-enabled cells, such as haptically-enabled cell 104. The haptically-enabled cells may be arranged in a matrix or other configuration. In some examples, a single haptically-enabled cell forms a single pixel of the visual display 102. In other examples, a single haptically-enabled cell forms multiple pixels of the visual display 102. The visual display 102 may include any number and combination of haptically-enabled cells in any suitable arrangement.

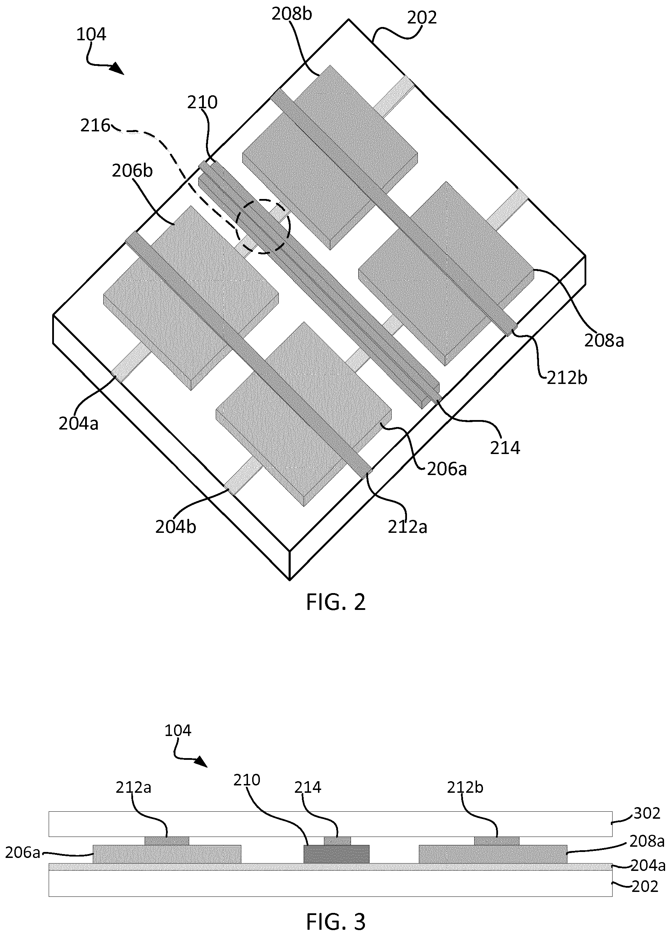

An example of the haptically-enabled cell 104 is shown in FIG. 2A. In this example, the haptically-enabled cell 104 includes a base substrate 202. The base substrate 202 is a foundational layer onto which other layers of the haptically-enabled cell 1 04 may be formed. The base substrate 202 may include metallic foil, plastic, silicon, germanium, aluminum, sapphire, or any combination of these. In some examples, the base substrate 202 is less than 2 millimeters (mm) thick.

The haptically-enabled cell 104 also includes one or more anodes 204a-b. The anodes 204a-b may be positioned on the base substrate 202. The anodes 204a-b include a conductive material for communicating electrical signals. Examples of the conductive material include gold, copper, lead, nickel, aluminum, zinc, or any combination of these.

The haptically-enabled cell 104 also includes one or more light-emitting elements 206a-b, 208a-b comprising one or more light-emitting materials. An example of a light-emitting element 206a-b, 208a-b can include a light-emitting diode. Examples of the light-emitting materials include indium tin oxide (ITO), aluminum zinc oxide, graphite, gallium arsenide (GaAs), gallium phosphide (GaP), indium gallium nitride (InGaN), aluminum gallium indium phosphate (AlGaInP), aluminum gallium arsenide (AlGaAs), a filament, a gas component, or any combination of these. In some examples, the light-emitting materials can include organic layers or polymers, such as poly(p-phenylene vinylene) (PPV). The light-emitting elements 206a-b, 208a-b may be positioned on the anodes 204a-b. For example, the light-emitting elements 206a-b, 208a-b may be electrically coupled to and positioned overtop of the anodes 204a-b. The light-emitting elements 206a-b, 208a-b emit visible light when stimulated. For example, the light-emitting elements 206a-b, 208a-b may emit visible light in response to an electrical signal (e.g., current, voltage, an electric field, etc.) being applied to the light-emitting elements 206a-b, 208a-b.

The light-emitting elements 206a-b may include a different material than light-emitting elements 208a-b. This may result in light-emitting elements 206a-b producing a different color than light-emitting elements 208a-b. For example, the light-emitting elements 206a-b may produce a red color. The light-emitting elements 208a-b may produce a blue color. The haptically-enabled cell 104 may include any number and combination of light-emitting elements 206a-b, 208a-b for producing any number and combination of colors (e.g., red, blue, green, yellow, etc.).

The haptically-enabled cell 104 also includes cathodes 212a-b. The cathodes 212a-b may be positioned on the light-emitting elements 206a-b, 208a-b. For example, the cathodes 212a-b may be electrically coupled to and positioned overtop of the light-emitting elements 206a-b, 208a-b. The cathodes 212a-b include a conductive material for communicating electrical signals. Electrical signals may be selectively applied to the anodes 204a-b, cathodes 212a-b, or both to stimulate one or more of the light-emitting elements 206a-b, 208a-b to generate visible light (e.g., for a pixel of the visual display 102).

The haptically-enabled cell 104 also includes a haptic output device 210. Examples of the haptic output device 210 include a dielectric elastomer, polyvinylidene difluoride (*PVDF*), a macro fiber composite (MFC) material, an electroactive polymer, a piezoelectric material, a smart material (e.g., a smart gel), a rheological fluid, a shape memory material (e.g., an alloy or ceramic), or any combination of these. The haptic output device 210 outputs a haptic effect in response to a stimulus. Examples of the stimulus include electricity, heat, or a chemical being applied to the haptic output device 210; an electric field or magnetic field being applied across the haptic output device 210; or any combination of these. In some examples, the haptic output device 210 is less than 2 mm thick.

In the example shown in FIG. 2, the haptic output device 210 is positioned above one or more of the anodes 204a-b. An electrode 214 (e.g., a cathode) is positioned overtop of the haptic output device 210. The haptic output device 210 is selectively operated by generating a voltage between at least one of the anodes 204a-b and the electrode 214, thereby applying a voltage across the haptic output device 210. In one example, the voltage across the haptic output device 210 may cause the haptic output device 210 to expand and contract in size, generating vibrations. A user may perceive the vibrations as a vibrotactile haptic effect. In another example, the haptic output device 210 includes a resistive material that produces heat in response to the voltage. A user may perceive the heat as a thermal haptic effect. In yet another example, the voltage across the haptic output device 210 causes the haptic output device 210 to deform in shape (e.g., bend, flex, or twist). The deformation of the haptic output device 210 may apply a force to an upper substrate (e.g., as discussed with respect to FIG. 3), causing the upper substrate to deform in shape. This, in turn, may cause a surface of the visual display to deform in shape. The user may perceive the deformation of the surface of the visual display as a deformation haptic effect. The haptic output device 210 may be configured to generate any number and combination of haptic effects.

In some examples, the entire haptic output device 210 is actuated all at once to generate a haptic effect. For example, applying a current to the haptic output device 210 via the electrode 214 may cause the entire haptic output device 210 to bend, vibrate, deform, or otherwise generate a haptic effect. In other examples, only a portion of the haptic output device 210 is actuated to generate a haptic effect. For example, a voltage can be generated between the electrode 214 and the anode 204a, thereby applying a voltage across only a portion 216 of the haptic output device 210. This may cause only the portion 216 of the haptic output device 210 to bend, vibrate, deform, or otherwise generate a haptic effect. In some examples, the portion 216 of the haptic output device 210 may be individually actuateable from other portions of the haptic output device 210, such as another portion that is between the electrode 214 and the anode 204b. Any number and combination of portions of the haptic output device 210 can be actuated sequentially or in concert to generate a haptic effect.

A cross-sectional side view of the haptically-enabled cell 104 is shown in FIG. 3. As shown, the haptically-enabled cell 104 includes the base substrate 202, the anode 204a, the light-emitting elements 206a, 208a, the cathodes 212a-b, the haptic output device 210, and the electrode 214. The haptically-enabled cell 104 also includes an upper substrate 302, which was omitted from FIG. 2 for clarity. The upper substrate 302 may be positioned above the cathodes 212a-b, the electrode 214, or both. The upper substrate 302 may protect the haptically-enabled cell 104 from damage, prevent electrical communication or interference between haptically-enabled cells, or both. Other examples may omit the upper substrate 302.

The components of the haptically-enabled cell 104 may be flexible. For example, the base substrate 202, anodes 204a-b, light-emitting elements 206a-b, 208a-b, cathodes 212a-b, haptic output device 210, electrode 214, upper substrate 302, or any combination of these may be flexible. This may result in the haptically-enabled cell 104 being flexible, which in turn may result in some or all of the visual display 102 being flexible. In some examples, the components of the haptically-enabled cell 104 are optically transparent. For example, the base substrate 202, anodes 204a-b, light-emitting elements 206a-b, 208a-b, cathodes 212a-b, haptic output device 210, electrode 214, upper substrate 302, or any combination of these may be optically-transparent or semi-transparent. This may reduce visual occlusion.

In some examples, the haptically-enabled cell 104 includes a touch sensor for detecting a contact with the visual display. The touch sensor may be formed from one or more of the abovementioned components of the haptically-enabled cell 104 or via additional components included in the haptically-enabled cell 104. In one example, a capacitance between the cathode 212a and a user's finger may be sensed by monitoring a change in voltage on the cathode 212a, thereby forming the touch sensor. In another example, a capacitance between the anode 204a and a user's finger may be sensed by monitoring a change in voltage on the anode 204a, thereby forming the touch sensor.

The examples described herein are illustrative and not intended to be limiting. A haptically-enabled cell 104 may include any number, combination, and configuration of the components discussed above, as well as additional or different components. For example, a haptically-enabled cell 104 may lack a light-emitting element 206a-b, 208a-b. As another example, the haptically-enabled cell 104 may include one or more transistors, light filters, liquid crystals, and/or other components. In another example in which the visual display 102 is an active-matrix OLED display, each individual haptically-enabled cell 104 may include a thin-film transistor backplane for switching the pixel on or off.

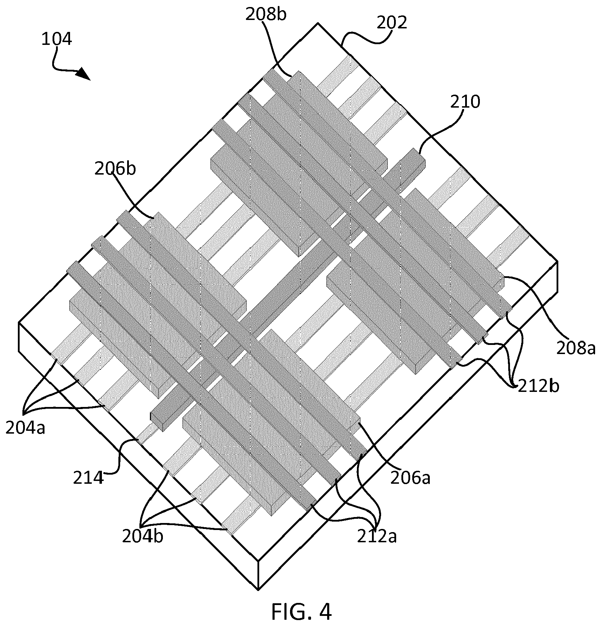

FIG. 4 is another example of a haptically-enabled cell 104 according to some aspects. In FIG. 4, the haptically-enabled cell 104 includes multiple anodes 204a-b coupled to each light-emitting element. For example, three anodes 204a are positioned underneath the light-emitting elements 206b, 208b. The haptically-enabled cell 104 also includes multiple cathodes 212a-b coupled to each light-emitting element. For example, three cathodes 212a are positioned overtop of the light-emitting elements 206a-b. Including multiple anodes 204a-b and/or multiple cathodes 212a-b for each light-emitting element may enable finer control of the light-emitting elements (e.g., to produce different hues, saturations, and brightness's for a pixel).

In the example shown in FIG. 4, the haptic output device 210 is positioned between the electrode 214 and one or more of the cathodes 212a-b. The haptic output device 210 may be selectively operated by generating a voltage between at least one of the cathodes 212a-b and the electrode 214, thereby applying a voltage across the haptic output device 210.

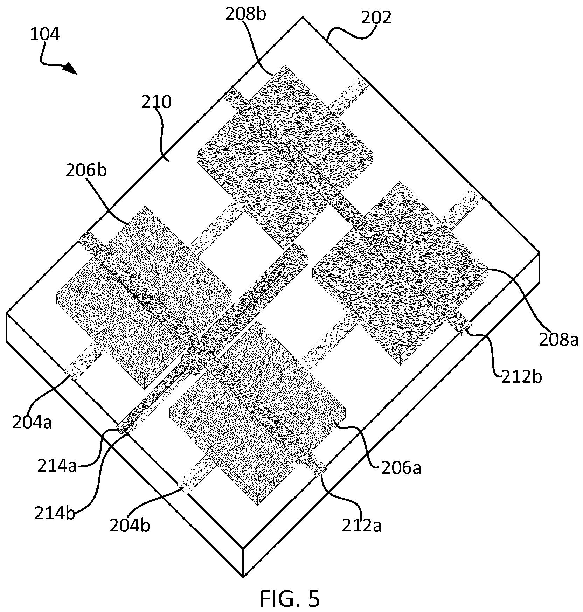

Another example of a haptically-enabled cell 104 is shown in FIG. 5. In FIG. 5, the haptic output device 210 is selectively controllable via two electrodes 214a-b. The electrodes 214a-b are separate from the anodes 204a-b and cathodes 212a-b, and the electrodes 214a-b may span an entire length of the haptic output device 210. The haptic output device 210 is also shorter, thinner, or otherwise differently shaped or sized than the haptic output devices of the previous figures. The haptic output device 210 may have any suitable size or shape.

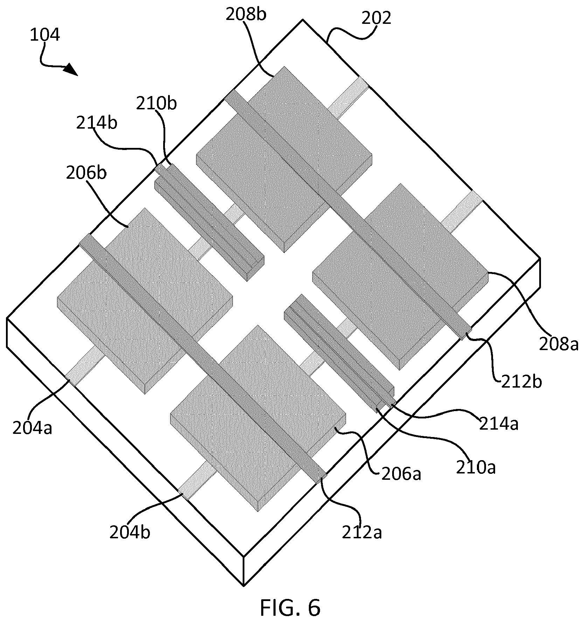

FIG. 6 is another example of a haptically enabled cell 104. In FIG. 6, the haptically-enabled cell 104 includes two haptic output devices 210a-b. Haptic output device 210a is selectively controllable via anode 204b and electrode 214a. Haptic output device 210b is selectively controllable via anode 204a and electrode 214b. The haptically-enabled cell 104 may include any number and combination of haptic output devices, in any configuration or orientation, for generating any number and combination of haptic effects.

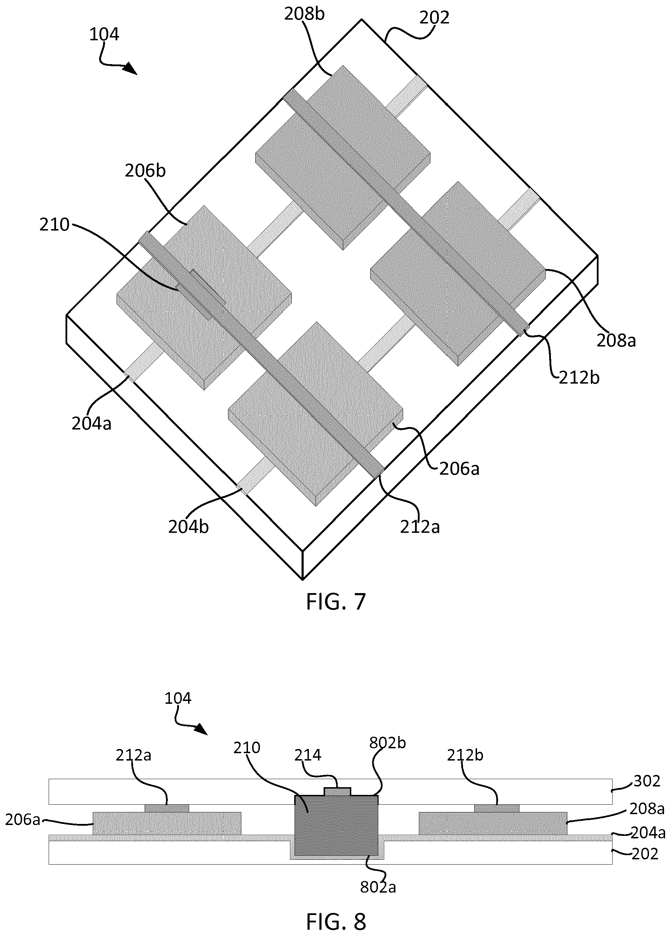

Another example of a haptically enabled cell 104 is shown in FIG. 7. In FIG. 7, the haptic output device 210 is incorporated into a light-emitting element, such as light-emitting element 206b. Although the haptic output device 210 is shown in FIG. 7 as positioned between the anode 204a and the cathode 212a, in other examples the haptic output device 210 may be positioned elsewhere in the light-emitting element. The haptic output device 210 may be operated independently of, or simultaneously with, the light-emitting element 206b by communicating electrical signals through the anode 204a, the cathode 212a, or both.

FIG. 8 is a cross-sectional side view of another example of a haptically-enabled cell 104 according to some aspects. In this example, the haptic output device 210 is coupled to the base substrate 202, the upper substrate 302, or both. For example, the haptic output device 210 can be bonded to the upper substrate 302 using glue, epoxy, or another adhesive.

The base substrate 202, the upper substrate 302, or both may be non-uniform in shape. For example, the base substrate 202 includes a recessed area 802a and the upper substrate 302 includes another recessed area 802b. The recessed areas 802a-b may be thinner than other areas of the substrates 202, 302. For example, the recessed area 802a may be 0.5 mm thick while another portion of the base substrate 202 may be 1 mm (or more) thick. The reduced thickness of the substrates 202, 302 may enable the haptic effects (e.g., vibrations) produced by the haptic output device 210 to more easily propagate through the substrates 202, 302. A user may perceive such haptic effects as stronger than if one or both of the substrates 202, 302 did not include the recessed areas 802a-b. One or both of the substrates 202, 302 may include any number and combination of recessed areas, hills, troughs, bumps, deformations, or other features for improving or inhibiting the propagation of haptic effects through the substrate(s).

In some examples, the substrates 202, 302 include materials that are configured to improve or inhibit the propagation of haptic effects through the substrate 202, 302. For example, the upper substrate 302 may include a rubber material to dampen haptic effects produced by the haptic output device 210. As another example, the upper substrate 302 may include a rigid material to improve transmission of haptic effects produced by the haptic output device 210.

The physical characteristics of other components of the haptically-enabled cell 104 may additionally or alternatively be configured to improve or inhibit propagation of haptic effects through the haptically-enabled cell 104. For example, the anode 204a, cathodes 212a-b, electrode 214, or any combination of these may be formed from a rigid material to improve transmission of haptic effects produced by the haptic output device 210.

The physical characteristics of the haptically-enabled cells forming the visual display 102 may be specifically configured to produce any desired haptic result. For example, the physical characteristics of the haptically enabled cells may be configured so that haptic effects are perceived as having a consistent level of strength across the surface of the visual display 102. As another example, the physical characteristics of the haptically enabled cells may be configured so that haptic effects are perceived as having varying levels of strength at different areas of the surface of the visual display 102.

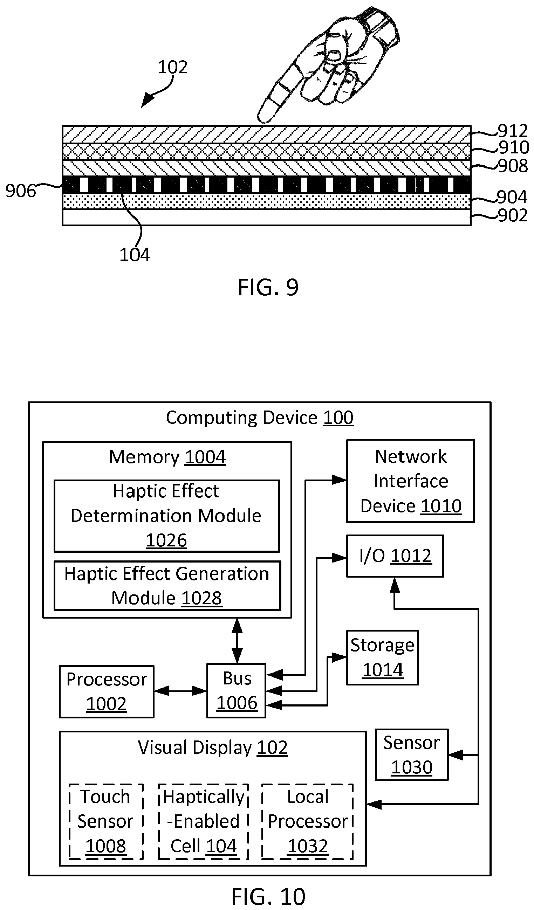

A cross-sectional side view of an example of the visual display 102 is shown in FIG. 9. In this example, the visual display 102 includes a bottom substrate 902. The bottom substrate 902 may include a glass material, such as a thin-film-transistor (TFT). The visual display 102 also includes a lower conductive-layer 904. The lower conductive-layer 904 may be positioned above the bottom substrate 902 and include a conductive material. The visual display 102 also includes a layer of haptically-enabled cells 906. The layer of haptically-enabled cells 906 may be positioned above the lower conductive-layer 904. Each haptically-enabled cell may form a pixel of the visual display 102. The haptically-enabled cells may include any number and combination of the examples discussed above. The visual display 102 also includes an upper substrate 908. The upper substrate 908 may be positioned above the layer of haptically-enabled cells 906 and include a glass material, such as a color filter (CF) glass. The visual display 102 further includes an upper conductive-layer 910. The upper conductive-layer 910 may be positioned above the upper substrate 908 and include a conductive material, such as indium tin oxide (ITO). Finally, the visual display 102 includes a polarizer layer 912. The polarizer layer 912 may be positioned above the upper conductive-layer 910 and include a glass material. Some or all of the components of the visual display 102 may be optically transparent or semi-transparent. And some or all of the components of the visual display 102 may be flexible to enable the visual display 102 to flex, bend, or otherwise deform.

In this example, the visual display 102 is a touch-screen display capable of detecting user input. For example, the visual display 102 may be a resistive touch-screen display in which a user interaction with the polarizer layer 912 causes the upper conductive-layer 910 to deform and contact the lower conductive-layer 904. This may complete an electrical circuit through which the user interaction can be detected. As another example, the visual display 102 may be a capacitive touch-screen display in which a user interaction with the polarizer layer 912 changes a capacitance. The change in capacitance may be detected and indicate that the user interaction occurred.

In other examples, the visual display 102 may include more, fewer, or different components than shown in FIG. 9. For example, the visual display 102 may not include the polarizer layer 912. As another example, the visual display 102 may include an anti-glare layer. In some examples, the visual display 102 may not include the lower conductive-layer 904, the upper conductive-layer 910, or both (e.g., because the visual display 102 is not touch sensitive, or because touch sensors are integrated into the haptically-enabled cells).

FIG. 10 is a block diagram of an example of a computing device 100 for implementing in-cell haptics according to some aspects. In this example, the computing device 100 includes a processor 1002 interfaced with other hardware via bus 1006. A memory 1004, which may include any suitable tangible (and non-transitory) computer-readable medium such as RAM, ROM, EEPROM, or the like, may embody program components that configure operation of the computing device 100. In some embodiments, the computing device 100 may further comprise one or more network interface devices 1010, input/output (I/O) interface components 1012, and additional storage 1014.

Network interface device 1010 may represent one or more of any components that facilitate a network connection or otherwise facilitate communication between electronic devices. Examples include, but are not limited to, wired interfaces such as Ethernet, USB, IEEE 1394, and/or wireless interfaces such as IEEE 802.11, Bluetooth, near-field communication (NFC) interfaces, RFID interfaces, or radio interfaces for accessing cellular telephone networks (e.g., transceiver/antenna for accessing a CDMA, GSM, UMTS, or other mobile communications network).

I/O components 1012 may be used to facilitate connection to devices such as one or more visual displays 102, keyboards, mice, speakers, microphones, buttons, and/or other hardware used to input data or output data. Storage 1014 represents nonvolatile storage such as read-only memory, flash memory, ferroelectric RAM (F-RAM), magnetic, optical, or other storage media included in the computing device 100 or coupled to processor 1002.

The computing device 100 may include the visual display 102. Alternatively, the computing device 100 may be physically separate from, but electrically coupled to, the visual display 102 (e.g., if the computing device 100 is a desktop computer and the visual display 102 is a computer monitor). Either way, the visual display 102 includes one or more haptically-enabled cells 104.

In some examples, the visual display 102 is touch-sensitive. For example, the visual display 102 may include one or more touch sensors 1008 configured to detect a contact and transmit signals associated with the contact to processor 1002. Any suitable number, type, or arrangement of touch sensors 1008 may be used. For example, resistive and/or capacitive sensors may be embedded in the visual display 102 and used to determine the location of a contact and other information, such as pressure, speed, and/or direction of the contact. Although the touch sensor 108 is shown in FIG. 10 as a separate component from the haptically-enabled cell 104, in other examples the touch sensor 1008 is integrated into the haptically-enabled cell 104.

In some examples, the visual display 102 may include a local processor 1032 that is separate from the processor 1002. The local processor 1032 may control the haptically-enabled cells 104, the touch sensor 1008, or both. For example, the local processor 1032 may receive touch input from the touch sensor 1008, process the touch input, and operate the haptically-enabled cell 104 to provide haptic feedback based on the touch input. In another example, the processor 1002 may communicate high-level commands or other information to the local processor 1032, which the local processor 1032 may interpret to produce haptic effects, visual images, or both. In some examples, the local processor 1032 may switch haptically-enabled cells 104 between a display-output mode for displaying a pixel of an image, a haptic-output mode for generating a haptic effect, an input mode for receiving touch input, or any combination of these, as needed.

In some examples, the visual display 102 can be controlled according to a matrix addressing scheme. For example, the haptically-enabled cells 104 of the visual display 102 can be arranged into a two-dimensional matrix, with each haptically-enabled cell 104 being at an intersection between a particular row and a particular column of the matrix. A haptically-enabled cell 104 may be enabled (e.g., to emit visible light, a haptic effect, or both) by activating a row and column associated with the haptically-enabled cell 104, thereby providing a closed current path that includes the haptically-enabled cell 104. In some examples, different drivers can be used to activate a light-emitting element 206a and a haptic output device 210 of a haptically-enabled cell 104, so that the light-emitting element 206a and the haptic output device 210 are individually controllable.

In some examples, the computing device 100 includes one or more sensor(s) 130. The sensor(s) 130 are configured to transmit sensor signals to the processor 1002. The sensor(s) 130 may comprise, for example, a camera, microphone, accelerometer, humidity sensor, ambient light sensor, gyroscope, GPS unit, range sensor, depth sensor, biosensor, a strain gauge, and/or temperature sensor.

Turning to memory 1004, illustrative program components 1026 and 1028 are depicted to illustrate how a device may be configured in some examples to provide haptic feedback. For example, haptic effect determination module 1026 may include program code for selecting a haptic effect to output based on user input or an event. An event may include any interaction, action, collision, or other occurrence during operation of the computing device 100 which can potentially have an associated haptic effect. For example, an event may include a system status, such as low battery or low memory; a system notification, such as a notification generated based on the computing device 100 receiving an incoming call; sending data; receiving data; or a program event, such as explosions, gunshots, collisions, character interactions, or level advancements in a video game.

The haptic effect determination module 1026 may additionally or alternatively include program code for selecting one or more haptically-enabled cells 104 to actuate to generate the selected haptic effect. For example, the haptic effect determination module 1026 may include a lookup table that relates locations on the visual display 102 to corresponding haptically-enabled cells 104. The haptic effect determination module 1026 may include program code that causes a processor 1002 to (i) determine a location on the visual display 102 at which to output the haptic effect, (ii) access the lookup table, and (ii) identify which haptically-enabled cells 104 corresponds to the determined location using the lookup table. The processor 1002 may then cause one or more haptic effects to be produced by the identified haptically-enabled cells 104.

Haptic effect generation module 1028 may include program code for generating and transmitting haptic signals to one or more haptically-enabled cells 104 to generate the selected haptic effect. For example, the haptic effect generation module 1028 may include program code that causes the processor 1002 to access a database of stored waveforms, select one of the stored waveforms as the haptic signal, and transmit the haptic signal to one or more haptically-enabled cells 104 to generate the selected haptic effect. In some examples, the haptic effect generation module 1028 includes algorithms for determining the haptic signals to transmit to the haptically-enabled cells 104 based on the selected haptic effect.

It will be appreciated that, in other examples, the computing device 100 may include more components, fewer components, different components, or a different configuration of the components than shown in FIG. 10. For example, although the memory 1004 is shown in FIG. 10 as being separate from the visual display 102, in other examples some or all of the components of memory 1004 may be additionally or alternatively be included in the visual display 102 (e.g., for use by the local processor 1032).

### Illustrative Methods for Providing In-Cell Haptics

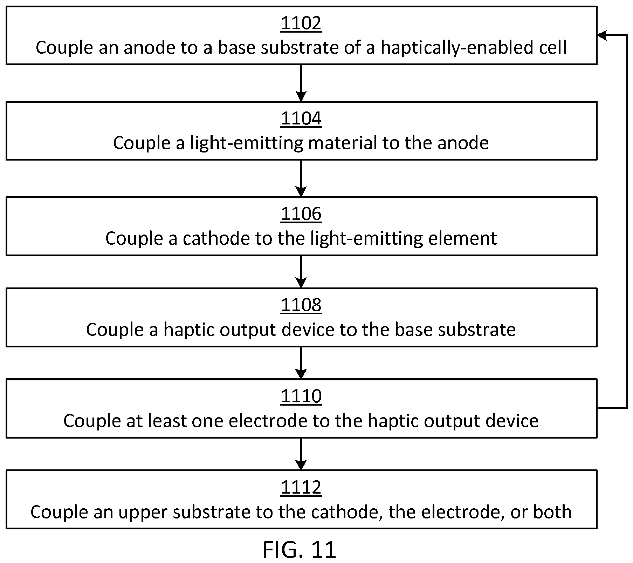

FIG. 11 is a flow chart of an example of a process for manufacturing a visual display that includes a haptically-enabled cell 104 according to some aspects. The steps of the process may be performed by hand, machine, or both. In some examples, one or more steps shown in FIG. 11 may be omitted or performed in a different order. Similarly, additional steps not shown in FIG. 11 may also be performed. The steps below are described with reference to components described above.

In step 1102, an anode 204a is coupled to a base substrate 202 of a haptically-enabled cell 104. For example, the base substrate 202 may be obtained or provided (e.g., from a vendor, distributor, or manufacturer). Then, the anode 204a may be formed onto, deposited onto, glued onto, etched into, positioned on, or otherwise attached to the base substrate 202.

In step 1104, a light-emitting element 206b is coupled to the anode 204a. For example, the light-emitting element 206b may be formed onto, deposited onto, glued onto, positioned on, or otherwise attached to the anode 204a. In some examples, the light-emitting element 206b is electrically coupled to the anode 204a to enable electrical communication (e.g., a flow of electrical current) between the light-emitting element 206b and the anode 204a.

In step 1106, a cathode 212a is coupled to the light-emitting element 206b. For example, the cathode 212a may be formed onto, deposited onto, glued onto, positioned on, or otherwise attached to the light-emitting element 206b. In some examples, the cathode 212a is electrically coupled to the light-emitting element 206b to enable electrical communication between the cathode 212a and the light-emitting element 206b.

In step 1108, a haptic output device 210 is coupled to the base substrate 202. For example, the haptic output device 210 may be formed onto, deposited onto, glued onto, etched into, positioned on, or otherwise attached to the base substrate 202. In some examples, the haptic output device 210 is additionally or alternatively coupled to the anode 204a, the cathode 212a, or both. For example, the haptic output device 210 may be electrically coupled to the anode 204a, the cathode 212a, or both to enable electrical communication between the haptic output device 210 and the anode 204a, the cathode 212a, or both.

The haptic output device 210 may be positioned in any suitable location within the haptically-enabled cell 104. For example, the haptic output device 210 may be positioned adjacent to the light-emitting element 206b, between two light-emitting elements 206a-b, within the light-emitting element 206b, below the light-emitting element 206b, or a combination of these. In some examples, the haptic output device 210 is incorporated into the light-emitting element 206b and steps 1104 and 1108 are combined.

In step 1110, at least one electrode 214 is coupled to the haptic output device 210. For example, at least one electrode 214 may be formed onto, deposited onto, glued onto, etched into, positioned on, or otherwise attached to the haptic output device 210. In some examples, the at least one electrode 214 may be electrically coupled to the haptic output device 210 to enable electrical communication between the at least one electrode 214 and the haptic output device 210. The at least one electrode 214 may be separate from the anode 204a and the cathode 212a, and may be usable to control the haptic output device 210 separately from the light-emitting element 206b.

In some examples, some or all of steps 1102-1110 are repeated to add additional components to the haptically-enabled cell 104. For example, steps 1102-1106 may be repeated to add another anode, light-emitting element, and cathode to the haptically-enabled cell 104 to enable the haptically-enabled cell 104 to produce more than one color of visible light. As another example, steps 1108-1110 may be repeated to add another (e.g., a different type of) haptic output device to the haptically-enabled cell 104.

In step 1112, an upper substrate 302 is coupled to the cathode 212a, the electrode 214, or both. For example, the upper substrate 302 may be formed onto, deposited onto, glued onto, positioned on, or otherwise attached to the cathode 212a, the haptic output device 210, the electrode 214, or any combination of these. The upper substrate 302 may be positioned such that a thinner portion of the upper substrate 302 is coupled to and/or contacting the haptic output device 210. This may enable haptic effects produced by the haptic output device 210 to more easily propagate through the haptically-enabled cell 104.

Some or all of the process of FIG. 11 can be repeated to create multiple haptically-enabled cells 104 that may collectively form a visual display 102. The process may be repeated any number of times to create any number of haptically-enabled cells 104 having the same or different characteristics.

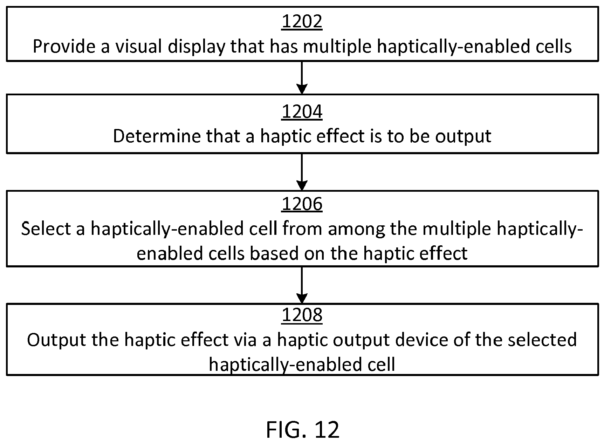

FIG. 12 is a flow chart of an example of a process for operating a visual display that includes a haptically-enabled cell 104 according to some aspects. The steps of FIG. 12 may be implemented in program code and/or executed by one or more processors (or "processing devices"). In some examples, one or more steps shown in Figure 12 may be omitted or performed in a different order. Similarly, additional steps not shown in Figure 12 may also be performed. The steps below are described with reference to components described above.

In step 1202, a visual display 102 that has multiple haptically-enabled cells 104 is provided. For example, the visual display 102 may be manufactured at least in part by performing the process shown in FIG. 11 and incorporated into (or electrically coupled with) a computing device 100.

In step 1204, a processing device (e.g., processor 1002 or local processor 1032 of computing device 100) determines that a haptic effect is to be output. In some examples, the processing device determines that a haptic effect is to be output based on an event. For example, the processing device may determine that the haptic effect is to be output based on the computing device 100 receiving certain content (e.g., a phone call, text message, e-mail, audio file, video file, streaming data, etc.); being in a certain physical location (e.g., in a store, mall, home, building, etc.); sending certain content; executing a certain application or piece of software (e.g., a game or utility); detecting a particular environmental characteristic via sensor 1030; or any combination of these.

In some examples, the processing device determines that the haptic effect is to be output based on user input. The user input may be provided via a touch-screen display (such as visual display 102), a mouse, a keyboard, or another user interface component. For example, a user may contact a GUI object (e.g., a virtual button, slider, image, icon, or menu) displayed on the visual display 102. The touch sensor 1008 may detect the contact and transmit sensor signals to the processing device. The processing device may then determine that the haptic effect is to be output based on the sensor signals.

In some examples, the processing device determines that the haptic effect is to be output via a lookup table that correlates events to haptic effects. The processing device may use the lookup table to map a detected event to a corresponding haptic effect. For example, the processing device may use the lookup table to map a particular event, such as receipt of a phone call, to a corresponding haptic effect, such as a high-magnitude vibration. In some examples, the lookup table may indicate that no haptic effect is to be output for certain events. For example, a particular event (e.g., opening a spreadsheet application) may not be listed in the lookup table, or may not have a corresponding haptic effect in the lookup table, which may indicate that no haptic effect is to be output.

In some examples, the processing device determines the haptic effect to output. For example, the processing device may use the haptic effect determination module 1026, the abovementioned lookup table, or an algorithm to determine which haptic effect to output in response to a particular event or combination of events. For example, a user may be playing a video game. In response to an explosion event in the video game, the processing device may access a lookup table to determine that the explosion event is mapped to a vibratory haptic effect. Thus, the processing device may select to output a vibratory haptic effect. The processor may then determine a magnitude and/or frequency for the vibratory haptic effect based on, for example, a relationship (e.g., algorithm) between the size of the explosion, the proximity of a user's virtual character to the explosion, and/or the device or material causing the explosion.

In step 1206, the processing device selects a haptically-enabled cell 104 based on the haptic effect. For example, the processing device may determine that the haptic effect is to be output to a lower-left region of the visual display 102 and select haptically-enabled cells 104 in that region to provide a localized haptic effect. As another example, the processing device may determine that the haptic effect is for simulating movement along the visual display 102 and select a group of haptically-enabled cells to sequentially actuate to generate the haptic effect. As yet another example, the processing device may determine that the haptic effect is to be output across the entire visual display 102 and select all of the haptically-enabled cells 104 in the visual display 102. The processing device may select any number and combination of haptically-enabled cells 104 to produce any number and combination of haptic effects.

In some examples, the processing device selects the haptically-enabled cell 104 by accessing a lookup table. The lookup table may map regions (e.g., pixels or sections) of the visual display 102 to haptically-enabled cells 104. In one example, the lookup table includes a list of regions of the visual display 102. Each region may be mapped to one or more haptically-enabled cells 104. The processing device may determine that the haptic effect is to be output to a particular region of the visual display 102 and use the lookup table to determine the haptically-enabled cells 104 that correspond to that region. For example, a user may contact a virtual button output on the visual display 102. The processing device may detect the contact (via touch sensor 1008) and determine that a haptic effect is to be output to the user. To output the haptic effect, the processing device may use the lookup table to determine which haptically-enabled cells 104 correspond to the region of the visual display 102 being contacted by the user. The processing device may then actuate those haptically-enabled cells 104 to produce the haptic effect, which can be felt by the user at the surface of the visual display 102.

In some examples, the processing device selects the haptically-enabled cell 104 using an algorithm. An example of the algorithm can include a mathematical relationship between a contact location on the visual display 102 and the physical location of haptically-enabled cells 104 associated with (e.g., positioned under) the contact location. The processing device can use the algorithm to determine which haptically-enabled cells 104 correspond to the contact location. The processing device may then actuate those haptically-enabled cells 104 to produce the haptic effect.

In step 1208, the processing device outputs the haptic effect via a haptic output device 210 of the selected haptically-enabled cell 104. For example, the processing device can transmit one or more haptic signals to the haptic output device 210 itself; to the anodes 204a-b coupled to the haptic output device 210; to the cathodes 212a-b coupled to the haptic output device 210; to the electrode(s) 214a-b coupled to the haptic output device 210; or any combination of these. The haptic signals may be electrical signals with characteristics (e.g., magnitude, frequency, duration, waveform, etc.) configured to cause the haptic output device 210 to produce the haptic effect. The haptic output device 210 may generate the haptic effect in response to the haptic signals. The processing device can transmit any number and combination of haptic signals to any number and combination of haptically-enabled cells 104 to generate the haptic effect.

In some examples, the processing device causes the haptic output device 210 to generate the haptic effect via one or more intermediary components. For example, the processing device can transmit electrical signals to an electrical circuit or component (e.g., a power source) coupled to the haptic output device 210. The electrical component can responsively generate a haptic signal (e.g., a binary string of bits or another waveform) and transmit the haptic signal to the haptic output device 210. The haptic output device 210 can then output the haptic effect in response to the haptic signal.

### Additional Systems and Devices for In-Cell Haptics

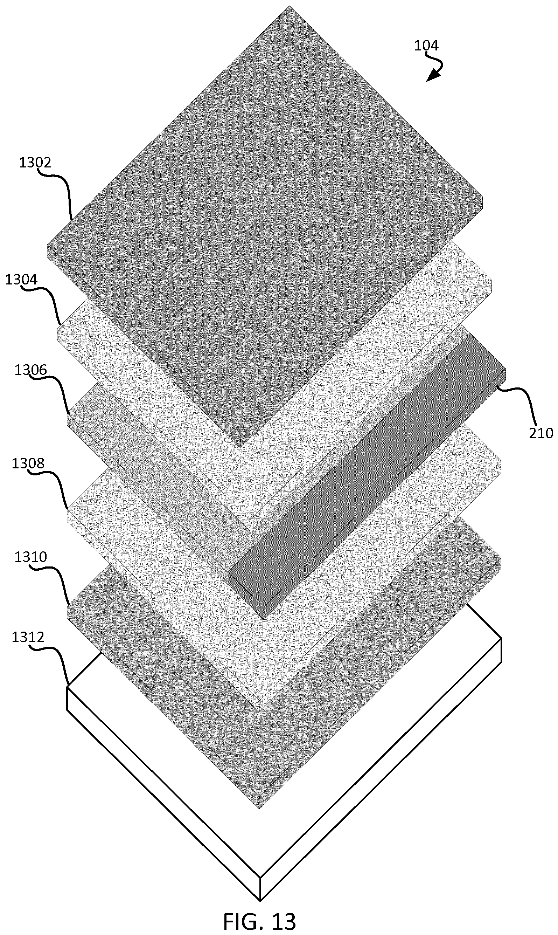

FIG. 13 is an exploded view of another example of a haptically-enabled cell 104 according to some aspects. In this example, the haptically-enabled cell 104 forms a pixel of an LCD.

The haptically-enabled cell 104 includes a polarizing filter 1302 with a vertical axis for polarizing light as the light enters the haptically-enabled cell 104. The haptically-enabled cell 104 also includes a first substrate 1304 (e.g., a glass substrate). The first substrate 1304 includes electrodes, such as indium tin oxide (ITO) electrodes. The first substrate 1304 may have vertical ridges that align with the vertical axis of the polarizing filter 1302. The haptically-enabled cell 104 also includes a liquid crystal layer 1306. The liquid crystal layer 1306 may include a twisted nematic ("TN")-type liquid crystal layer(s) or an in-plane switching ("IPS")-type liquid crystal layer(s). In this example, the haptically-enabled cell 104 further includes a second substrate 1308. The second substrate 1308 includes electrodes, such as ITO electrodes. The second substrate 1308 may have horizontal ridges that align with a horizontal axis of another polarizing filter 1310. The haptically-enabled cell 104 also includes a base substrate 202. The base substrate 202 may include a reflective material for reflecting light back to a viewer, or a light source (e.g., if the LCD is a backlit LCD).

In this example, the haptically-enabled cell 104 also includes a haptic output device 210. The haptic output device 210 can be positioned within the liquid crystal layer 1306 or elsewhere in the haptically-enabled cell 104. The haptic output device 210 can be actuated via electrodes in the first substrate, the second substrate, or both according to one or more of the methods discussed elsewhere in the present disclosure.

In some examples, the physical characteristics of one or more components of the haptically-enabled cell 104 are configured to improve or inhibit propagation of haptic effects through the haptically-enabled cell 104 (e.g., as discussed above with respect to FIG. 8). For example, the polarizing filter 1302, first substrate 1304, or both may be non-uniform in shape. In one particular example, the polarizing filter 1302 and the first substrate 1304 have recessed areas for improving propagation of vibrations through the haptically-enabled cell 104.

Other examples can include more components, fewer components, different components, or a different combination of the components shown in FIG. 13. For instance, some examples may include additional haptic output devices 210 positioned in the liquid crystal layer 1306 and/or other layers of the haptically-enabled cell 104.

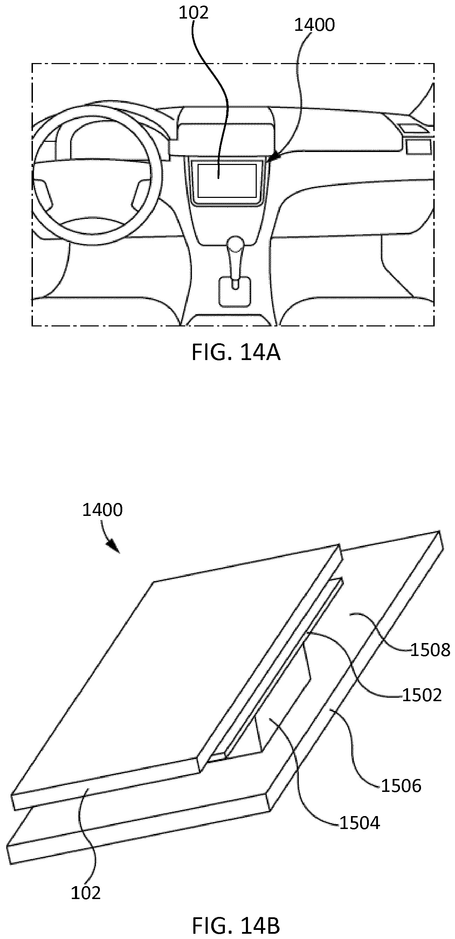

FIGS. 14A-B are examples of a vehicle computing-system 1400 for producing in-cell haptics according to some aspects. The vehicle computing-system 1400 may be part of an in-vehicle user interface system, such as a central console system and/or vehicle dashboard system used to provide user interaction for various functionality, such as viewing and/or controlling vehicle status, cabin temperature, navigation, radio, calls and text, or other functionality.

The vehicle computing-system 1400 includes a visual display 102. The visual display 102 includes haptically-enabled cells 104. The haptically-enabled cells 104 may be arranged in a matrix and configured to provide haptic effects and visual information to a user. In this example, the visual display 102 is touch-sensitive for receiving touch input.

In some examples, the vehicle computing-system 1400 may include a mounting system 1502 for supporting the visual display 102. The mounting system 1502 may act as a suspension system that supports a weight of the visual display 102. A mounting support 1504 can attach the visual display 102 and the mounting system 1502 to a mounting surface 1508 of a body 1506, such as a body of a dashboard or center console of a vehicle. For example, the mounting support 1504 may be a rigid block that is attached to the mounting system 1502 at one end and attached to the mounting surface 1508 at the other end.

A user can press a location of the visual display 102 to provide touch input. For example, the user can press on the visual display 102 to select a button displayed on the visual display 102, or to provide some other user input. In one example, as a user presses or otherwise applies an external force on the touch surface of the visual display 102, the mounting system 1502 may deform. An actuator or set of actuators of the mounting system 1502 may also be deformed by the external force, and may act as a transducer or set of transducers by converting the deformation to one or more electrical signals. Each of the one or more electrical signals may be considered a sensor signal that can be used to detect the touch input. In response to detecting the touch input at the location, the vehicle computing-system 1400 can activate one or more haptically-enabled cells 104 of the visual display 102 to provide one or more haptic effects corresponding to the touch input. For example, the vehicle computing-system 1400 can activate a group of haptically-enabled cells 104 at the touch location to generate a vibration at the touch location.

In some examples, the mounting system 1502 also provides haptic effects when a user applies an external force to the visual display 102. For example, the mounting system 1502 may deform by an amount that is perceptible to a user in response to the user applying an external force to the visual display 102. In such an example, the deformation may be used to simulate, e.g., a mechanical button being depressed. For instance, as the user presses a location on the visual display 102, the mounting system 1502 may deform by a sufficient amount that is detectable to a user, and thus may be able to assist in reproducing the feeling of a button being pressed. The user may perceive this deformation in conjunction with one or more other haptic effects output by the haptically-enabled cells 104 of the visual display 102, such as a vibration output by the visual display 102. Thus, the mounting system 1502 may complement the haptic effects provided by the visual display 102.

### Advantages of In-Cell Haptics

There are numerous advantages of in-cell haptics. Visual displays that include haptically-enabled cells may be thinner, cheaper, easier to install, and/or easier to manufacture than other types of haptic feedback devices. For example, a retailer may choose to install new interactive displays in its stores. The interactive displays may include haptically-enabled cells capable of providing visual output, touch sensing, and haptic feedback all in a single, integrated unit that makes installation simple. As another example, a smartphone manufacturer may wish to incorporate haptic feedback into its next smartphone. Rather than having to incorporate separate display and haptic components into the smartphone, the smartphone manufacturer can simply incorporate a visual display that includes haptically-enabled cells. This may be a cheaper, faster, and less cumbersome.

In some examples, visual displays that include haptically-enabled cells can produce haptic effects that are highly localized. For instance, some examples can produce haptic effects that are targeted to particular areas of the visual display, rather than vibrating the entire visual display or computing device (which may result in confusing, noisy, or muddled haptic effects).

Some examples of the present disclosure can be flexible, bendable, or otherwise deformable and still capable of producing haptic effects. For example, a visual display that includes haptically-enabled cells can be conformed around a cylindrical column in a store, a user's wrist as part of a smart watch, a user's finger as part of a smart ring, or a curved surface of a wall. The visual display may still be able to receive touch input, provide haptic output, or both.

### General Considerations

The methods, systems, and devices discussed above are examples. Various configurations may omit, substitute, or add various procedures or components as appropriate. For instance, in alternative configurations, the methods may be performed in an order different from that described, and/or various stages may be added, omitted, and/or combined. Also, features described with respect to certain configurations may be combined in various other configurations. Different aspects and elements of the configurations may be combined in a similar manner. Also, technology evolves and, thus, many of the elements are examples and do not limit the scope of the disclosure or claims.

Specific details are given in the description to provide a thorough understanding of example configurations (including implementations). However, configurations may be practiced without these specific details. For example, well-known circuits, processes, algorithms, structures, and techniques have been shown without unnecessary detail in order to avoid obscuring the configurations. This description provides example configurations only, and does not limit the scope, applicability, or configurations of the claims. Rather, the preceding description of the configurations will provide those skilled in the art with an enabling description for implementing described techniques. Various changes may be made in the function and arrangement of elements without departing from the spirit or scope of the disclosure.

Also, configurations may be described as a process that is depicted as a flow diagram or block diagram. Although each may describe the operations as a sequential process, many of the operations may be performed in parallel or concurrently. In addition, the order of the operations may be rearranged. A process may have additional steps not included in the figure. Furthermore, examples of the methods may be implemented by hardware, software, firmware, middleware, microcode, hardware description languages, or any combination thereof. When implemented in software, firmware, middleware, or microcode, the program code or code segments to perform the necessary tasks may be stored in a non-transitory computer-readable medium such as a storage medium. Processors may perform the described tasks.

Having described several example configurations, various modifications, alternative constructions, and equivalents may be used without departing from the spirit of the disclosure. For example, the above elements may be components of a larger system, wherein other rules may take precedence over or otherwise modify the application of the visual displays, methods and devices disclosed herein. Also, a number of steps may be undertaken before, during, or after the above elements are considered. Accordingly, the above description does not bound the scope of the claims.

The use of "adapted to" or "configured to" herein is meant as open and inclusive language that does not foreclose devices adapted to or configured to perform additional tasks or steps. Additionally, the use of "based on" is meant to be open and inclusive, in that a process, step, calculation, or other action "based on" one or more recited conditions or values may, in practice, be based on additional conditions or values beyond those recited. Headings, lists, and numbering included herein are for ease of explanation only and are not meant to be limiting.

Examples in accordance with aspects of the present subject matter may be implemented in digital electronic circuitry, in computer hardware, firmware, software, or in combinations of the preceding. In one example, a computer may comprise a processor or processors. The processor comprises or has access to a computer-readable medium, such as a random access memory (RAM) coupled to the processor. The processor executes computer-executable program instructions stored in memory, such as executing one or more computer programs including a sensor sampling routine, selection routines, and other routines to perform the methods described above.

Such processors may comprise a microprocessor, a digital signal processor (DSP), an application-specific integrated circuit (ASIC), field programmable gate arrays (FPGAs), and state machines. Such processors may further comprise programmable electronic devices such as PLCs, programmable interrupt controllers (PICs), programmable logic devices (PLDs), programmable read-only memories (PROMs), electronically programmable read-only memories (EPROMs or EEPROMs), or other similar devices.

Such processors may comprise, or may be in communication with, media, for example tangible computer-readable media, that may store instructions that, when executed by the processor, can cause the processor to perform the steps described herein as carried out, or assisted, by a processor. Examples of computer-readable media may comprise, but are not limited to, all electronic, optical, magnetic, or other storage devices capable of providing a processor, such as the processor in a web server, with computer-readable instructions. Other examples of media comprise, but are not limited to, a floppy disk, CD-ROM, magnetic disk, memory chip, ROM, RAM, ASIC, configured processor, all optical media, all magnetic tape or other magnetic media, or any other medium from which a computer processor can read. Also, various other devices may comprise computer-readable media, such as a router, private or public network, or other transmission device. The processor, and the processing, described may be in one or more structures, and may be dispersed through one or more structures. The processor may comprise code for carrying out one or more of the methods (or parts of methods) described herein.

While the present subject matter has been described in detail with respect to specific examples thereof, it will be appreciated that those skilled in the art, upon attaining an understanding of the foregoing may readily produce alterations to, variations of, and equivalents to such examples. Accordingly, it should be understood that the present disclosure has been presented for purposes of example rather than limitation, and does not preclude inclusion of such modifications, variations and/or additions to the present subject matter as would be readily apparent to one of ordinary skill in the art.

## Claims

1. A visual display (102) for displaying one or more images, the visual display comprising:
a haptically-enabled cell (104) forming a pixel of the visual display (102), the haptically-enabled cell including:
an anode (204a);
a cathode (212a);
a light-emitting element (206a) comprising a light-emitting material, the light-emitting element (206a) positioned between the anode (204a)and the cathode (212a), the light-emitting material being configured to emit visible light in response to an electrical signal communicated by the anode or the cathode; and
a haptic output device (210) configured to output a haptic effect in response to a haptic signal.

2. The visual display of claim 1, wherein the haptic output device (210) includes a smart material, a piezoelectric material, or a shape memory material.

3. The visual display of claim 1 or claim 2, wherein the haptically-enabled cell (104) includes at least one electrode (214) coupled to the haptic output device (210) and configured to control the haptic output device (210) separately from the light-emitting element (206a), the at least one electrode (214) being separate from the anode (204a) and the cathode (212a), and optionally wherein the haptic signal includes a voltage applied across (i) the at least one electrode (214), and (ii) the anode (204a) or the cathode (212a).

4. The visual display of any preceding claim, wherein:
the anode is a first anode (204a);
the cathode is a first cathode (212a);
the light-emitting element is a first light-emitting element (206a);
the haptically-enabled cell (104) further comprises:
a second anode (204b);
a second cathode (212b); and
a second light-emitting element (206b) positioned between the second anode (204b) and the second cathode (212b), the second light-emitting element (206b) being different from the first light-emitting element (206a) and configured to emit visible light in response to another electrical signal communicated by the second anode (204b) or the second cathode (212b); and
the haptic output device (210) is positioned between the first light-emitting element (206a) and the second light-emitting element (206b).

5. The visual display of any preceding claim, further comprising a plurality of haptically-enabled cells forming a plurality of pixels, each haptically-enabled cell (104) of the plurality of haptically-enabled cells being individually controllable to generate haptic effects.

6. The visual display of any preceding claim, wherein the or each haptically-enabled cell (104) further comprises a base substrate (202) on which the anode (204a, b) is positioned and an upper substrate (302) positioned overtop of the cathode (212a, b), and optionally wherein one or more of the following:
the haptic output device (210) is configured to deform a surface of the visual display (102) by bending in an amount configured to apply a force to the upper substrate (302), the force configured to cause the upper substrate (302) to change shape and thereby cause the surface of the visual display (102) to deform; or
the upper substrate (302) is non-uniform in thickness and has a thickest portion, and wherein the haptic output device (210) is configured to output the haptic effect to a portion (802a) of the upper substrate (302) that is thinner than the thickest portion.

7. The visual display of any preceding claim, wherein the haptically-enabled cell further comprises a touch sensor (1008).

8. The visual display of any preceding claim, wherein the haptic output device (210), the or each haptically-enabled cell (104), and the visual display (102) are deformable.

9. The visual display of any preceding claim, wherein the visual display (102) is a light-emitting diode (LED) display having a plurality of pixels arranged in a two-dimensional matrix, each pixel of the plurality of pixels comprising a respective haptically-enabled cell (104), and optionally wherein the plurality of haptically enabled cells (104) are selectively operable according to a matrix addressing scheme.

10. A method of manufacturing a visual display (102) that includes a haptically-enabled cell (104) forming a pixel of the visual display, the method comprising:
coupling an anode (204a) to a base substrate (202) of the haptically-enabled cell (104);
coupling a light-emitting element (206a) to the anode (204a), the light-emitting element comprising a light-emitting material configured to emit visible light in response to an electrical signal communicated by the anode (204a) or a cathode (212a);
coupling the cathode (212a) to the light-emitting element (206a); and
coupling a haptic output device (210) to the base substrate (202), the haptic output device (210) being configured to output a haptic effect in response to a haptic signal.

11. A method for operating a display comprising haptically-enabled cells, the method comprising:
providing a visual display (102) comprising a plurality of haptically-enabled cells (104) forming a plurality of pixels of the visual display, each haptically-enabled cell of the plurality of haptically-enabled cells including:
an anode (204a);
a cathode (212a);
a light-emitting element (206a) comprising a light-emitting material, the light-emitting element positioned between the anode (204a) and the cathode (212a), the light-emitting material being configured to emit visible light in response to an electrical signal communicated by the anode (204a) or the cathode (212a); and
a haptic output device (210) configured to output haptic effects in response to haptic signals;
determining, by a processing device (1032), that a haptic effect is to be output;
selecting, by the processing device (1032), a haptically-enabled cell (104) from among the plurality of haptically-enabled cells based on the haptic effect; and
outputting the haptic effect via the haptic output device (210) of the selected haptically-enabled cell (104).

12. The method of claim 11, further comprising:
displaying an image on the visual display (102) at least in part by stimulating the light-emitting element (206a) in the selected haptically-enabled cell (104) by communicating the electrical signal via the anode (204a) or the cathode (212a).

13. The method of claim 11 or claim 12, further comprising:
detecting a contact with the visual display (102) based on a sensor signal from a touch sensor (1008) incorporated into the selected haptically-enabled cell (104); and
determining the haptic effect based on the contact with the visual display (102).

14. A device comprising:
a plurality of haptically-enabled cells (104) arranged in a matrix, each haptically-enabled cell of the plurality of haptic cells comprising:
an anode (204a);
a cathode (212a);
a light-emitting element (206a) comprising a light-emitting material, the light-emitting element positioned between the anode (204a) and the cathode (212a), the light-emitting material being configured to emit visible light in response to an electrical signal communicated by the anode (204a) or the cathode (212a); and
a haptic output device (210) configured to output a haptic effect in response to a haptic signal.

15. The device of claim 14, wherein each haptically-enabled cell (104) is independently controllable from a remainder of the plurality of haptically-enabled cells, and wherein the light-emitting element (206a) is individually controllable from the haptic output device (210) in each haptically-enabled cell.
